# EUROPEAN PATENT SPECIFICATION

(11) **EP 2 415 094 B1**
(45) Date of publication and mention of the grant of the patent: **29.07.2015**
(21) Application number: 10758249.6
(22) Date of filing: 29.03.2010
(51) Int. Cl.: H01L 51/50, H01L 51/52, B82Y 20/00, B82Y 30/00

(54) **LIGHT EMITTING DEVICE**
LICHTEMITTIERENDE VORRICHTUNG
DISPOSITIF ÉLECTROLUMINESCENT

(30) Priority: 30.03.2009 JP 2009082791
(43) Date of publication of application: 08.02.2012
(73) Proprietor: UDC Ireland Limited, Dublin 4 (IE)
(72) Inventor: YASUDA, Hideki, Ashigarakami-gun Kanagawa 258-8577 (JP); NAYA, Masayuki, Ashigarakami-gun Kanagawa 258-8577 (JP); SOTOYAMA, Wataru, Ashigarakami-gun Kanagawa 258-8577 (JP)
(74) Representative: Maiwald Patentanwalts GmbH
(86) International application number: PCT/JP2010/002288
(87) International publication number: WO 2010/113469

(56) References cited:
- JP-A- 2007 329 363
- US-A1- 2005 035 346
- US-A1- 2007 114 523

## Description

### Technical Field

The present invention relates to an electric-field light emitting device (electroluminescence device), which emits light by application of an electric field, and particularly to an electroluminescence device that can emit light with high efficiency.

### Background Art

Electroluminescence devices (EL devices), such as an organic EL device, an LED (light emitting diode), and a semiconductor laser, are structured in such a manner that electrode layers, a light emitting layer and the like are deposited (stacked, superposed or the like) one on another on a substrate. Generally, light generated in the light emitting layer is extracted through a transparent electrode. However, when light enters the interface of the light-extracting-side layer at an angle greater than or equal to a critical angle by influence of the refractive index of each layer, total reflection occurs. Therefore, the light is trapped in the electroluminescence device, and it is impossible to extract the light therefrom. Hence, highly efficient extraction of emitted light is difficult. For example, when the refractive index of the transparent electrode is the refractive index of ITO (indium-tin oxide) or the like, which is often used as the material of the transparent electrode, the light extraction efficiency is said to be approximately 20%.

For example, in an organic EL device, it is known that when an organic material is present in an excited state for a long period of time, the chemical bond of the organic material breaks inherently, and that the light emitting performance of the organic EL device deteriorates as time passes. It is essential to solve this problem when the organic material is used as the material of the electroluminescence device (light emitting device). Further, as long as fluorescence is used, generation efficiency at an upper level (an upper energy level or state) is theoretically limited to 25%, and it is impossible to increase the light emitting efficiency more than this level. In principle, when phosphorescence is used and intersystem crossing is promoted, it is possible to induce the upper level including only triplets. Therefore, the theoretical limit may be increased to the range of 75% to 100%. However, the lifetime of the triplet in the upper level is longer than that of fluorescence, which is emitted in allowed transition, and the probability of collision between excitons is high. Therefore, the light emitting efficiency is lower. Further, the device deteriorates faster, and the durability of the device is low.

As described above, the light emitting efficiency and the extraction efficiency of the EL device are low. Therefore, the utilization efficiency of the emitted light is extremely low. Hence, the utilization efficiency needs to be improved.

As an approach to improving the light emitting efficiency (or enhancing light emission), W. Li et al., "Emissive Efficiency Enhancement of Alq3 and Prospects for Plasmon-enhanced Organic Electroluminescence", Proc. of SPIE, Vol. 7032, pp.703224-1 - 703224-7, 2008 (Non-Patent Document 1) proposes a method of utilizing a plasmon enhancement effect. In the method of utilizing the plasmon enhancement effect, metal (island form pattern is desirable) is arranged in the vicinity (for example, a few dozens of nanometers) of the light emitting layer to enhance the light emission. Plasmons (or localized plasmons) are induced on the surface of the metal by radiation of dipoles from the light emitting layer. After energy is absorbed, light is radiated again, and the newly emitted light enhances the light emission. Therefore, the new transition to light emission by plasmons is added to the light emitting process of the light emitting device. Hence, the lifetime (excitation lifetime) in the upper level can be reduced. When the plasmon enhancement is utilized, improvement in the light emitting efficiency and improvement in durability by reduction of the excitation lifetime may be expected.

As an approach to improving the light extraction efficiency, Japanese Unexamined Patent Publication 2007-165284 (Patent Document 1), US 2007/0114523, discloses an EL device including a light scattering layer. The light scattering layer is provided to solve the problem that the light extraction efficiency is low because light emitted from a light emitting layer is totally reflected at the interface between the light emitting layer and a layer next to the light emitting layer, and confined or trapped in the device. The light scattering layer includes a dielectric layer and metal microparticles contained in the dielectric layer. In the EL device, when total reflection occurs, the metal microparticles resonate by near field light scattered from the interface of the light emitting layer, and plasmons are induced. Light is radiated by the induced plasmons, and the radiation light is extracted from the device. Patent Document 1 describes that the light confined in the light emitting layer can be scattered to the outside of the light emitting layer.

However, in Non-Patent Document 1, enhancement of light emission by the plasmon enhancement effect is confirmed only in a light-excitation-type light emitting device (photoluminescence device: PL device), and no successful case has been reported. Non-Patent Document 1 describes that insertion of a metal layer into the EL device causes charge trap, thereby inhibiting the flow of electrons and positive holes from the electrodes to the light emitting layer. Further, Non-Patent Document 1 describes that the carrier balance is broken, and the light emission is suppressed rather than being enhanced.

Meanwhile, in the EL device disclosed in Patent Document 1, the metal microparticle is arranged in a dielectric layer. Therefore, the effect of charge trap can be prevented. However, the movement (transport) layer of charges (electrons and holes) is divided by the dielectric layer. Therefore, the flow of electrons and holes is also inhibited, and a risk of affecting light emission exists.

US 2005/0035346, discloses an organic light emitting device, wherein nanoparticles are included in either the light emitting layer or a transport layer. The nanoparticles are metal/ dielectric core shell particles. This document addresses the problem of non-radiative Forster type processes and accelerates the radiative decay of triplet emitters resulting in increased efficiency.

### Disclosure of Invention

In view of the foregoing circumstances, it is an object of the present invention to provide an EL device that can achieve high light emitting efficiency without lowering the durability of the device.

An electroluminescence device of the present invention is an electroluminescence device as described in claim 1.

Here, the term "electroluminescence device" is used as a general term for a device that emits light by application of an electric field, and which includes an organic EL device, an inorganic EL device, a light emitting diode (LED), and a semiconductor laser (LD: laser diode).

In the electroluminescence device of the present invention, it is desirable that at least a part of the at least one core-shell-type microparticle is arranged in the light emitting region and/or on the surface of the light emitting region.

Further, in the electroluminescence device of the present invention, it is desirable that a multiplicity of core-shell-type microparticles are dispersed in the light emitting region.

To achieve a more effective plasmon effect, it is desirable that the at least one core-shell-type microparticle is arranged in such a manner that a distance between the surface of at least one metal microparticle core in the at least one core-shell-type microparticle and the light emitting region is less than or equal to 30 nm. Further, it is desirable that the particle diameter of the metal microparticle core is greater than or equal to 10 nm and less than or equal to 1 um(micro meter). Here, the term "particle diameter" refers to the longest diameter (length) of the metal microparticle core.

When the electroluminescence device is an organic EL device, it is desirable that the plurality of layers include at least an electron transport layer, a light emitting layer, and a positive hole transport layer, and each of which is an organic layer. When the electroluminescence device is structured in such a manner, it is desirable that the core-shell-type microparticles are dispersed on the surface of the electron transport layer or the positive hole transport layer, or in the electron transport layer or the positive hole transport layer.

The electroluminescence device of the present invention includes a microparticle in the vicinity of a light emitting region or in the light emitting region. The microparticle induces plasmon resonance on the surface thereof by light emitted from the light emitting region. The microparticle is structured as a core-shell-type microparticle including at least one metal microparticle core and an insulation shell that covers the at least one metal microparticle core. When the microparticle is structured in such a manner, the metal microparticle (metal microparticle core) is coated with an insulator. Therefore, the flow of electrons and positive holes are not prevented by charge trap. Further, transition to light emission by plasmons can enhance light emission and reduce the lifetime (excitation lifetime) in the upper level. Consequently, it is possible to greatly improve the light emission efficiency and the durability of the device by reduction of the excitation lifetime.

Further, in the electroluminescence device of the present invention, the entire surface of the metal microparticle (metal microparticle core) is covered with an insulator. Therefore, the core-shell-type microparticle may be placed on the surface of the light emitting layer or in the light emitting layer. When the metal microparticle core is provided on the surface of the light emitting layer or in the light emitting layer, transition to light emission by plasmons is more effectively induced.

### Brief Description of Drawings

[fig.1]Figure 1 is a schematic diagram illustrating the structure of layers of an EL device (organic EL device) according to an example, not forming part of the present invention;
[fig.2]Figure 2 is a schematic cross-sectional diagram illustrating the structure of a core-shell-type microparticle including a plurality of metal microparticle cores;
[fig.3]Figure 3 is a schematic diagram illustrating the structure of layers of an EL device including elongated core-shell-type microparticles, according to the present invention;
[fig.4]Figure 4 is a schematic diagram illustrating the structure of layers of an EL device including metal microparticle cores in a light emitting layer; and [fig.5]Figure 5 is a schematic diagram illustrating the structure of layers of an inorganic LED

### Best Mode for Carrying out the Invention

### <Electroluminescence (EL) Device>

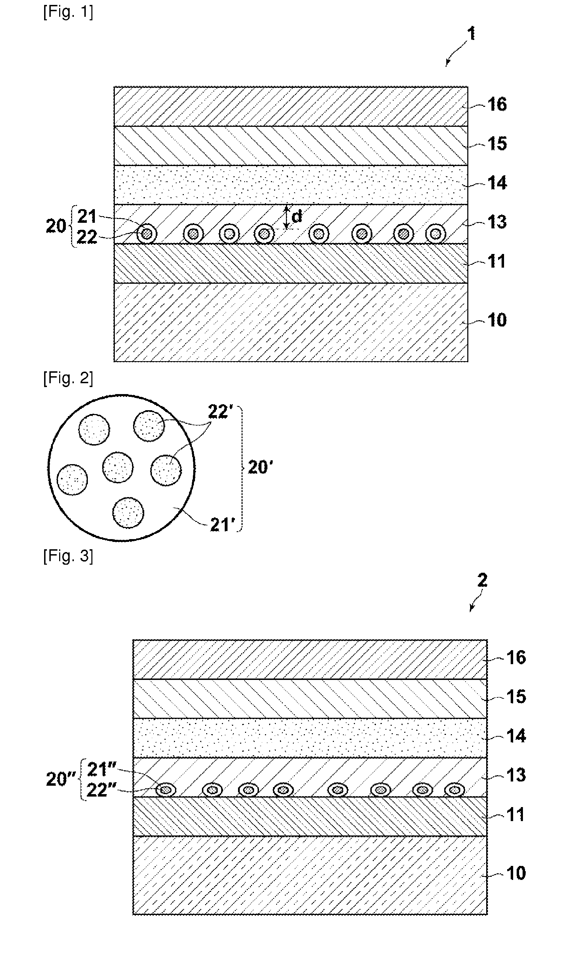

With reference to drawings, an electroluminescence device (EL device) will be described. Figure 1 is a schematic cross-sectional diagram illustrating the structure of an EL device according to an example, not forming part of the present invention.
In Figure 1, elements are appropriately illustrated at different scales from the actual sizes thereof so that the elements are easily recognizable.

As illustrated in Figure 1, an electroluminescence device (EL device) 1 includes an anode 11, a positive hole transport layer 13, a light emitting layer (light emitting region) 14, an electron transport layer 15, and a cathode 16 on a light-transmitting substrate (transparent substrate) 10, which transmits light. In the EL device (organic EL device) 1, a multiplicity of core-shell-type microparticles 20, as microparticles that induce plasmon resonance by light emitted from the light emitting layer 14, are dispersed in the positive hole transport layer 13. The core-shell-type microparticle 20 includes a metal microparticle core 22 and an insulation shell 21, which covers (coats) the metal microparticle core 22. The insulation shell 21 is made of a light transmitting material, which transmits the light emitted from the light emitting layer 14. Here, the term "light-transmitting" means that the transmittance with respected to the emitted light is higher than or equal to 70%.

The light-transmitting substrate 10 is not particularly limited, and a glass substrate, a quartz substrate, a flexible substrate made of polymer or the like may be used.

The light emitting layer 14 is not particularly limited as long as it is adoptable as a light emitting layer of an organic EL device. For example, the light emitting layer 14 may be made of a phenanthroline derivative (BCP) or the like. The organic EL device 1 emits light when electrons and positive holes injected from the anode 11 and the cathode 16, respectively, recombine with each other in the region of the light emitting layer 14.

The core-shell-type microparticle 20 is arranged in the vicinity of the light emitting region (light emitting layer) 14 so that plasmon resonance is induced by the light emitted from the light emitting region 14.

The position at which the core-shell-type microparticle 20 is arranged is not particularly limited as long as the metal microparticle (metal microparticle core) 22 of the core-shell-type microparticle 20 is located in a region in which plasmon resonance by the light emitted from the light emitting layer 14 is inducible. When the distance between the light emitting layer 14 and the metal microparticle (metal microparticle core) 22 is too long, it becomes difficult to induce plasmon resonance by the emitted light, and it is impossible to achieve an effective light emission enhancement effect. Therefore, it is desirable that distance d between the surface of the metal microparticle (metal microparticle core) 22 and the light emitting layer 14 is less than or equal to 30 nm. In the organic EL device of the present example, the metal microparticle (metal microparticle core) 22 is covered by the insulation shell 21. Therefore, the core-shell-type microparticle 20 including the metal microparticle core 22 may be arranged in the light emitting layer 14, and the electrodes layers (anode and cathode) 11, 16.

As the material of the metal microparticle (metal microparticle core) 22, a material that induces plasmon resonance by emitted light should be used. For example, Ag (silver), Au (gold), Cu (copper), Al (aluminum), Pt (platinum) or an alloy containing one of these metals as a main component (greater than or equal to 80%) may be used. When the emitted light has a wavelength in the visible light range, silver is desirable, because silver can induce surface plasmon resonance in the visible light range because of the plasma frequency. When the wavelength of the emitted light is not in the visible light range, for example, if the wavelength of the emitted light is in an infrared ray range, it is desirable that the material is gold.

Meanwhile, as the material of the insulation shell 21, an insulator such as SiO₂, AbO₃ , MgO, ZrO₂, PbO, B₂O₃, CaO and BaO, which transmits the emitted light, may be used.

Each of the layers 13 through 15 is designed to have a refractive index and a thickness so that the light emitting layer is located at the loop of the standing wave formed in the organic EL device.

As described in the section, "Background Art" of this specification, when a metal member, such as a metal microparticle, in an exposed state is inserted into the layers of the EL device, charges are trapped in the metal during application of an electric field, because the work function of the metal is higher than the work function of each layer. Therefore, the flow of charges is prevented, and the carrier balance is broken. Consequently, the efficiency of recombination of charges becomes lower, and the light emission is suppressed rather than being enhanced. When the metal microparticle is arranged in a dielectric layer, the influence of the charge trap may be prevented. However, a movement (transport) layer of charges (electrons and positive holes) is blocked by the dielectric layer. Therefore, the flow of electrons and positive holes is also prevented, and a risk of affecting light emission exists.

In the present example, the core-shell-type microparticle 20, as a metal member that induces plasmon resonance on the surface thereof by emitted light, is used to prevent such an adverse effect on light emission. The core-shell-type microparticle 20 is formed, for example, by using a silver microparticle as the metal microparticle core 22 and a dielectric, such as SiO₂, as the insulation shell 21. The silver microparticle 22, which contributes to plasmon resonance, is covered by the insulation shell 21. Therefore, even when an electric field is applied between the electrodes, charges (electrons or positive holes) are not trapped in Ag, and the charges flow through the movement layer that has a higher conductivity than that of the dielectric layer. Hence, the flow of charges is not prevented, and the light emitting layer can achieve the plasmon enhancement effect.

Next, an example of a method for producing the EL device 1 will be described briefly.
The anode 11 made of ITO (indium-tin oxide) is formed on the glass substrate 10 by vapor deposition. As the core-shell-type microparticle 20, a microparticle 22 of Ag having a particle diameter of 50 nm is coated with SiO₂ 21 with the thickness of 10 nm. Next, the core-shell-type microparticles 20 are dispersed in dichloromethane, in which a triphenyl diamine derivative (TPD), as a positive hole transport material, is dissolved. Further, the solution is applied to the anode 11 by spin coating, and the solvent is dried. Accordingly, the positive transport layer 13, in which the core-shell-type microparticles 20 are dispersed, is formed.

Next, a phenanthroline derivative (BCP), as a light emitting material, and Alq3(tris-(8-hydroxyquinoline)aluminum), as an electron transport material, are sequentially deposited by vapor deposition to form the light emitting layer 14 and the electron transport layer 15, respectively. Finally, the cathode 16 made of Al is formed to obtain the organic EL device 1.

In the aforementioned example, the core-shell-type microparticles 20 are dispersed in the positive hole transport layer 13. Alternatively, as described above, the core-shell-type microparticles 20 may be arranged or dispersed in any layer between the electrodes as long as plasmon resonance by the emitted light is inducible in the region in which the core-shell-type microparticles 20 are arranged. When the core-shell-type microparticles 20 are present in the light emitting region 14, it is possible to more effectively induce plasmon resonance, and that is desirable.

In Figure 1, the multiplicity of core-shell-type microparticles 20 are present. However, even if only one core-shell-type microparticle 20 is present, it is possible to enhance the light emission effect by the plasmon resonance.

In Figure 1, a single metal microparticle core 22 is provided in an insulation shell 21. Alternatively, a core-shell-type microparticle 20' including a plurality of metal microparticle cores 22' in an insulation shell 21', as illustrated in Figure 2, may be adopted.

The particle diameter of the metal microparticle core 22 of the core-shell-type microparticle 20 is not particularly limited as long as localized plasmons are induced. It is desirable that the particle diameter of the metal microparticle core 22 is less than or equal to the wavelength of the emitted light. Optionally, the particle diameter may be greater than or equal to 10 nm and less than or equal to 1 um(micro meter).

It is desirable that the thickness of the insulation shell 21 does not prevent induction of localized plasmons at the metal microparticle cores 22 by the emitted light. It is desirable that a distance between the light emitting layer 14 and the surface of the metal microparticle core 22 is less than or equal to 30 nm to effectively induce plasmons by the light emitted from the light emitting layer 14. Therefore, it is desirable that the position at which the core-shell-type microparticle 20 is arranged, the structure or arrangement of the layer, and the thickness of the insulation shell 21 are designed so that effective plasmon resonance is induced. Here, the thickness of the insulation shell 21 is an average distance between the surface of the insulation shell 21 and the surface of the metal microparticle core when only one metal microparticle 22 is included in the insulation shell 21. When the plurality of metal microparticle cores 20' are included in the insulation shell 21', as illustrated in Figure 2, the thickness of the insulation shell 21' is an average value of a shortest distance between the surface of the insulation shell 21' and each of the metal microparticle cores 22'.

As illustrated in Figure 3, in an organic EL device 2 according to the present invention, a multiplicity of elongated microparticles are used as core-shell-type microparticles 20" or the metal microparticles cores 22" (the aspect ratio of the major axis of the elongated microparticle to the minor axis of the elongated microparticle, which is perpendicular to the major axis, is greater than 1). In the organic EL device 2, the multiplicity of elongated core-shell-type microparticles 20" may be arranged in such a manner that the minor axes of the microparticles are oriented in a direction substantially perpendicular to the surfaces of the electrodes.

When the organic EL device 2 is structured in such a manner, it is possible to obtain scattered light the intensity of which is higher on the light extraction side because of the anisotropy of the form of the elongated core-shell-type microparticle 20". Hence, it is possible to achieve higher light emission efficiency.

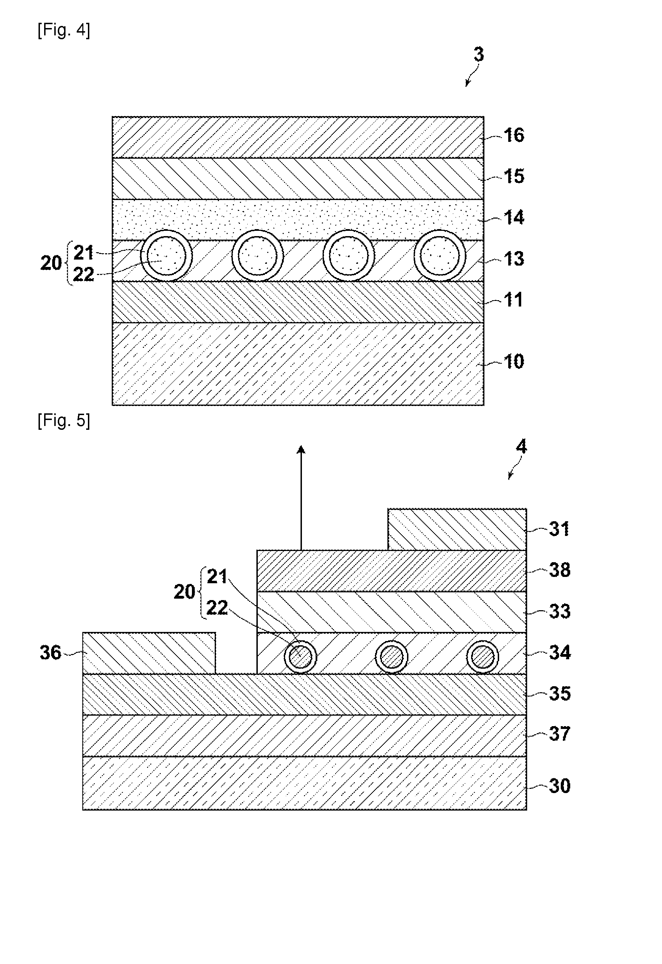

Further, as illustrated in Figure 4, the core-shell-type microparticle 20 may be arranged in such a manner that the metal microparticle (metal microparticle core) 22 is located in the light emitting layer 14. As already described, when the metal microparticle 22 is present in the light emitting region (light emitting layer) 14, transition to light emission by plasmon resonance is more effectively induced.

In an organic EL device 3, illustrated in Figure 4, the core-shell-type microparticle 20 is present in both of a layer (the positive hole transport layer 13) next to the anode 11 and the light emitting layer 14. When the organic EL device 3 is structured in such a manner, it is possible to easily produce the organic EL device 3 by providing the core-shell-type microparticles 20 by spin coating, as described above.

The organic EL devices 1 through 3 include microparticles 20 (20', 20"), which induce plasmon resonance on the surface thereof by light emitted from the light emitting region (light emitting layer) 14, in the vicinity of the light emitting region 14 or in the light emitting region 14. Further, the microparticle 20 (20', 20") includes at least one metal microparticle core 22 (22', 22") and an insulation shell 21 (21', 21"), which covers the at least one metal microparticle core 22 (22', 22"). When the microparticle 20 (20', 20") is structured in such a manner, the metal microparticle (metal microparticle core) 22 (22', 22") is coated with the insulation shell 21 (21', 21"). Therefore, the flow of electrons and positive holes is not prevented by charge trap, and it is possible to induce transition to light emission by plasmons, thereby achieving a light emission enhancement effect and an effect of reducing the lifetime (excitation lifetime) in the upper level. Accordingly, it is possible to greatly improve the light emission efficiency and the durability of the device by the reduction of the excitation lifetime.

In the organic EL devices 1 through 3, the entire surface of the metal microparticle 22 (22', 22") is covered by the insulation shell 21 (21', 21"). Therefore, the metal microparticle 22 (22', 22") may be arranged on the surface of the light emitting region (light emitting layer) 14 or in the light emitting region (light emitting layer) 14. When the metal microparticle 22 (22', 22") is provided on the surface of the metal layer 14 or in the metal layer 14, transition to light emission by plasmons is more effectively induced.

For example, in the EL devices as described above, layers are sequentially deposited on the substrate from the anode side, and light is extracted from the anode side. Each of layers other the metal thin-film may be formed by using the material and deposition methods of conventional organic EL devices.

In the above examples, each of the cathode, the electron transport layer, the light emitting layer, the positive hole transport layer, the anode, and the like may be made of materials selected from various well-known materials, each having an appropriate function. Further, a positive hole block layer, an electron block layer, a protective layer or the like may be provided.

Further, in each of the examples, an organic EL device in which the plurality of layers including the light emitting layer are organic compound layers has been described. Alternatively, the EL device of the present invention may be an inorganic EL device, in which the plurality of layers including the light emitting layer are inorganic compound layers. Further, the EL device of the present invention may be appropriately applied to a light emitting diode (LED) including a plurality of semiconductor layers and a semiconductor laser.

Next, an example in which the present invention is applied to an inorganic LED will be described. Figure 5 is a diagram illustrating an example in which the core-shell-type microparticles 20 are dispersed in an InGaN/GaN multilayer quantum well structure of a blue LED.

The inorganic LED 4 illustrated in Figure 5 may be produced, for example, in the following manner. First, a sapphire substrate 30 is prepared, and a low-temperature buffer layer (GaN) 37 and an n-type clad layer 35 (n-GaN) are sequentially deposited on the (001) surface of the sapphire substrate 30 by using organic metal vapor phase growth method (Metal Organic Chemical Vapor Deposition: MOCVD). After then, the sapphire substrate 30 on which the low-temperature buffer layer (GaN) 37 and the n-type clad layer 35 (n-GaN) are deposited is removed from the chamber. Further, the core-shell-type microparticles 20 are dispersed on the n-type clad layer 35 by spin coating.

In this example, the core-shell-type microparticles 20 were applied and dispersed by spin coating by using a coating liquid (application solution). In the coating liquid, the core-shell-type microparticles 20 were dispersed in dichloromethane. The core-shell-type microparticle 20 included a Ag microparticle with a particle diameter of 50 nm, and the Ag microparticle was coated with a coating of SiO₂ with a thickness of 10 nm. After the spin coating, the solvent was dried.

Further, the multilayer quantum well structure (light emitting layer) 34 and a p-type clad layer (p-GaN) 33 were sequentially deposited. The multilayer quantum well structure 34 may be produced, for example, by alternately depositing quantum well of In_{0.2}Ga_{0.8}N and a barrier layer of GaN by using the MOCVD method. The p-type clad layer 33 may also be deposited by using the MOCVD method.

Next, electrode portions of the inorganic LED are formed. First, photolithography and etching are performed to partially expose the n-type clad layer 35. Next, an ITO (indium-tin oxide), as a transparent electric current diffusion layer 38, is deposited on the p-type clad layer 33. Finally, Cr/Au is vapor-deposited, as electrodes 31 and 36, on the electric current diffusion layer 38 and an n-type semiconductor layer 35 by using an EB method. Accordingly, the LED structure is completed.

The inorganic LED 4 and the aforementioned organic EL devices have different device structures from each other. However, the inorganic LED 4 has a similar structure to the organic EL device 1 through 3 in that the inorganic LED 4 includes microparticles 20, which induce plasmon resonance on the surface thereof by light emitted from the light emitting region (light emitting layer) 34, in the vicinity of the light emitting region 34 or in the light emitting region 34. Further, the inorganic LED 4 has a similar structure in that the core-shell-type microparticle of the inorganic LED 4 includes at least one metal microparticle core 22 and an insulation shell 21 that covers the at least one metal microparticle core 22. Therefore, the inorganic LED 4 achieves beneficial effects similar to the effects of the organic EL devices 1 through 3. Therefore, the inorganic LED 4 can achieve high light emission efficiency and high durability by reduction of the excitation lifetime.

In the organic LED 4, the core-shell-type microparticle 20 may be arranged in the quantum well structure 34, which is a light emitting layer. When the core-shell-type microparticle 20 is arranged in such a manner, plasmons are highly efficiently induced on the metal microparticle core 22 of the core-shell-type microparticle 20 in the light emitting layer by the light emitted in the light emitting layer. Therefore, it is possible to very effectively achieve the light emission enhancement effect and the effect of reducing the lifetime (excitation lifetime) in the upper level by transition to light emission by plasmons.

Further, the EL device of the present invention may be appropriately applied to a display device or element, a display, a back light, an electronic photograph, a light source for lighting, a light source for recording, a light source for exposure, a light source for readout, a sign or mark, a signboard, an interior decoration or object, optical communication, and the like.

## Claims

1. A device, which is a electroluminescence device (1) comprising:
(i) electrodes (11, 16);
(ii) a plurality of layers (12, 13, 15) deposited one on another between the electrodes and, between them,
(iii) a light emitting region (14) emitting light by application of an electric field between the electrodes, and
(iv) arranged in the vicinity of or in the light emitting region, at least one core- shell-type microparticle (20) including at least one metal microparticle core (22) and an insulation shell (21) covering it, which induces plasmon resonance on the surface thereof by the light emitted from the light emitting region.
wherein the microparticle (20) or the metal microparticle core (22) is elongated, such that the aspect ratio of the major axis to the minor axis being perpendicular thereto is > 1, and **characterized in that** a multiplicity of elongated microparticles (20, 22) are arranged such that the minor axes thereof are oriented in a direction substantially perpendicular to the surfaces of the electrodes (11, 16).

2. The device of claim 1, wherein at least a part of the at least one microparticle (20) is arranged in the light emitting region and/or on the surface thereof.

3. The device of claim 2, wherein a multiplicity of microparticles (20) are dispersed in the light emitting region (14).

4. The device of any of claims 1-3, wherein the at least one microparticle (20) is arranged such that the distance between the surface of the at least one metal microparticle core (22) and the light emitting region (14) is ≤ 30 nm.

5. The device of any of claims 1-4, wherein the particle diameter of the metal microparticle core (22) is 10 nm to 1 *µ*m.

6. The device of any of claims 1-5, wherein the plurality of layers (12, 13, 15) include at least an electron transport layer (15), a light emitting layer (14), and a positive hole transport layer (13), each of which is an organic layer.

7. The device of claim 6, wherein the multiplicity of microparticles (20) are dispersed in the electron transport layer (15).

8. The device of claim 6, wherein the multiplicity of microparticles (20) are dispersed in the positive hole transport layer (13).

## Patentansprüche

1. Vorrichtung, welche eine elektrolumineszierende Vorrichtung (1) ist, umfassend:
(i) Elektroden (11, 16),
(ii) eine Vielzahl von Schichten (12, 13, 15) aufeinander aufgebracht zwischen den Elektroden
und, zwischen ihnen,
(iii) ein lichtemittierender Bereich 14, welcher bei Anbringung eines elektrischen Feldes zwischen den Elektroden Licht emittiert, und
(iv) angeordnet in der Nähe oder in dem lichtemittierenden Bereich mindestens ein Kern-Schale-artiges Mikropartikel (20) umfassend mindestens einen metallischen Mikropartikelkern (22) und eine isolierende Schale (21) welche diesen bedeckt, und welches Plasmonresonanz auf seiner Oberfläche induziert durch das aus dem lichtemittierenden Bereich ausgestrahlte Licht,
wobei das Mikropartikel (20) oder der metallische Mikropartikelkern (22) länglich ist, so dass das Aspektverhältnis der Hauptachse zur dazu senkrecht stehenden Nebenachse größer als 1 ist, und **dadurch gekennzeichnet, dass** eine Vielzahl an länglichen Mikropartikeln (20, 22) so angeordnet sind, dass deren Nebenachsen in einer Richtung orientiert sind, die im Wesentlichen senkrecht zu den Oberflächen der Elektroden 11, 16 ist.

2. Vorrichtung nach Anspruch 1, wobei mindestens ein Teil des mindestens einen Mikropartikels (20) in dem lichtemittierenden Bereich und/oder an dessen Oberfläche angeordnet ist.

3. Vorrichtung nach Anspruch 2, wobei eine Vielzahl von Mikropartikeln (20) in dem lichtemittierenden Bereich (14) verteilt sind.

4. Vorrichtung nach einem der Ansprüche 1 bis 3, wobei das mindestens eine Mikropartikel (20) so angeordnet ist, dass die Distanz zwischen der Oberfläche des mindestens einen metallischen Mikropartikelkerns (22) und dem lichtemittierenden Bereich (14) ≤ 30 nm ist.

5. Vorrichtung nach einem der Ansprüche 1 bis 4, wobei der Partikeldurchmesser des metallischen Mikropartikelkerns (22) 10 nm bis 1 µm beträgt.

6. Vorrichtung nach einem der Ansprüche 1 bis 5, wobei die Vielzahl von Schichten (12, 13, 15) mindestens eine Elektronentransportschicht (15), eine lichtemittierende Schicht (14), und eine positive Lochtransportschicht (13) umfassen, wobei jede dieser eine organische Schicht ist.

7. Vorrichtung nach Anspruch 6, wobei die Vielzahl von Mikropartikeln (20) in der Elektronentransportschicht (15) verteilt sind.

8. Vorrichtung nach Anspruch 6, wobei die Vielzahl von Mikropartikeln (20) in der positiven Lochtransportschicht (13) verteilt ist.

## Revendications

1. Dispositif, lequel est un dispositif électroluminescent (1) comportant :
(i) des électrodes (11, 16),
(ii) une pluralité de couches (12, 13, 15) disposées les unes sur les autres entre les électrodes et, entre elles,
(iii) une région d'émission de lumière (14) émettant de la lumière par application d'un champ électrique entre les électrodes, et
(iv) disposée à proximité de la région d'émission de lumière ou dans celle-ci, au moins une microparticule de type coque - noyau (20) comprenant au moins un noyau de microparticule métallique (22) et une coque d'isolation (21) recouvrant celui-ci, qui génère une résonance plasmonique sur la surface de celle-ci par la lumière émise depuis la région d'émission de lumière,
dans lequel la microparticule (20) ou le noyau de microparticule métallique (22) est allongé, de sorte que le rapport d'aspect du grand axe sur le petit axe étant perpendiculaire à celui-ci est > 1, et **caractérisé en ce que**
une multitude de microparticules allongées (20, 22) sont disposées de sorte que les petits axes correspondants sont orientés dans une direction sensiblement perpendiculaire aux surfaces des électrodes (11, 16).

2. Dispositif selon la revendication 1, dans lequel au moins une partie d'au moins une microparticule (20) est disposée dans la région d'émission de lumière et/ou sur la surface de celle-ci.

3. Dispositif selon la revendication 2, dans lequel une multitude de microparticules (20) sont dispersées dans la région d'émission de lumière (14)

4. Dispositif selon l'une quelconque des revendications 1 à 3, dans lequel la au moins une microparticule (20) est disposée de sorte que la distance entre la surface d'au moins un noyau de microparticule métallique (22) et la région d'émission de lumière (14) est ≤ 30 nm.

5. Dispositif selon l'une quelconque des revendications 1 à 4, dans lequel le diamètre de particules du noyau de microparticule métallique (22) est de 10 nm à 1 µm.

6. Dispositif selon l'une quelconque des revendications 1 à 5, dans lequel la pluralité de couches (12, 13, 15) comprennent au moins une couche de transport d'électrons (4), une couche d'émission de lumière (14), et une couche de transport à trou positif (13), chacune d'entre elle étant une couche organique.

7. Dispositif selon la revendication 6, dans lequel la multitude de microparticules (20) sont dispersées dans la couche de transport d'électrons (15).

8. Dispositif selon la revendication 6, dans lequel la multitude de microparticules (20) sont dispersées dans la couche de transport à trou positif (13).
